# FASCICULE DE BREVET EUROPEEN

(11) **EP 0 975 053 B1**
(45) Date de publication et mention de la délivrance du brevet: **30.10.2002**
(21) Numéro de dépôt: 99401802.6
(22) Date de dépôt: 19.07.1999
(51) Int. Cl.: H01R 12/04, H05K 3/34

(54) **Contact électrique pour montage d'un module sur un circuit rigide**
Elektrischer Kontakt zum Verbinden eines Moduls auf einer starren Leiterplatte
Electrical contact for mounting a module on a rigid circuit board

(30) Priorité: 23.07.1998 FR 9809426
(43) Date de publication de la demande: 26.01.2000
(73) Titulaire: Proner Comatel, 38530 Chapareillan (FR)
(72) Inventeur: Arnoul, Francois, 94520 Perigny-sur-Yerres (FR)
(74) Mandataire: Laget, Jean-Loup

(56) Documents cités:
- EP-A- 0 394 588

## Description

L'invention concerne un contact électrique pour montage d'un module sur un circuit rigide selon la prèambule de la revendication 1.

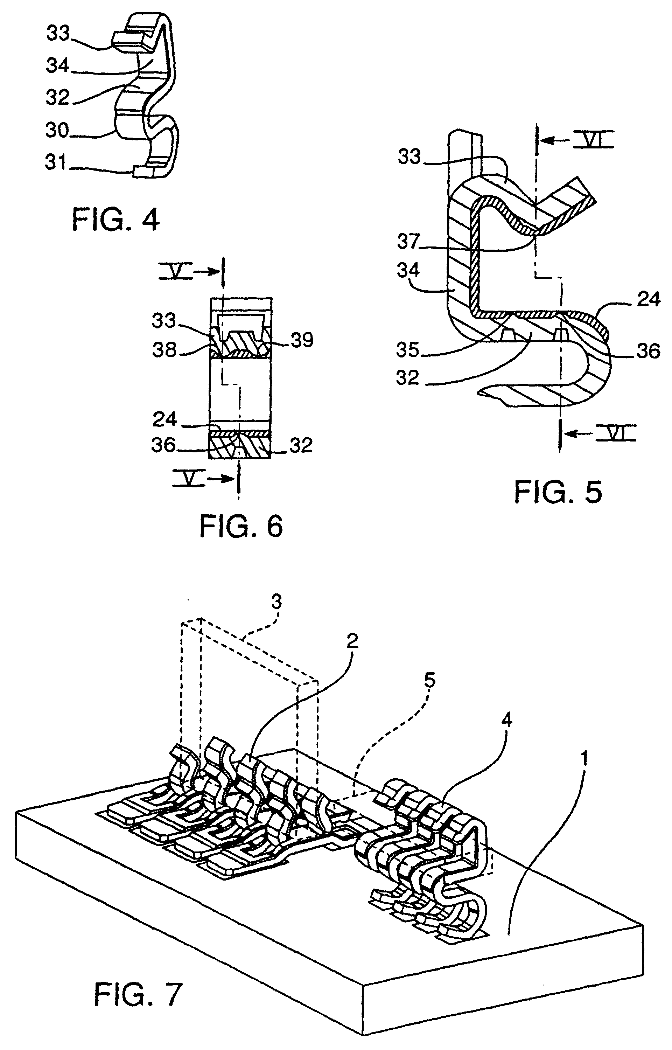

Des contacts électriques de ce type sont utilisés pour monter des modules soit perpendiculairement, soit parallèlement à un circuit rigide. Usuellement, ces contacts comportent un ou deux pieds destinés à être fixés par brasage sur le circuit rigide, et une pince recouverte de brasure, destinée à être fixée au module par brasage. Des exemples de tels contacts sont représentés sur la figure 7.

Sur le circuit rigide 1 sont disposés d'une part des contacts 2 à deux pieds pour le montage d'un module 3 perpendiculairement au circuit rigide 1, d'autre part des contacts 4 à un pied pour le montage d'un module 5 parallèlement au circuit rigide 1. Dans chaque cas, plusieurs contacts, 2 ou 4 respectivement, sont prévus pour chaque module, 3 ou 5 respectivement.

La brasure qui recouvre la partie intérieure de la pince de ces contacts est d'épaisseur constante. Lors de l'introduction du module dans la pince, la brasure est râpée et peut perdre ses qualités mécaniques de maintien du module.

De plus, lors de la refusion de la brasure, la couche de brasure au droit des zones d'appui des pinces sur le module devient fluide. Mais l'élasticité des bras des pinces n'est pas toujours suffisante pour compenser totalement l'épaisseur de la couche de brasure, et il en résulte une diminution de l'effort mécanique de maintien du module qui peut avoir pour conséquence un décalage des contacts ou un jeu au niveau des contacts.

Pour éviter cet inconvénient, le document EP 0 394 588 prévoit un contact à pince dont chaque bras est plié en dièdre dans sa partie centrale avec fluage de la brasure vers les bords du dièdre, les arêtes des dièdres étant disposées dans la direction d'insertion du module. Ainsi, lorsque le module est inséré, il entre en contact avec les pinces des contacts au niveau des arêtes des dièdres où l'épaisseur de brasure est la plus faible.

Outre la difficulté mécanique de réalisation de ce pliage des bras de pince dans leur région centrale, ces contacts ne résolvent pas le problème du pivotement par rapport au module.

En effet, pour des raisons de commodité de réalisation, les contacts sont fabriqués en série à partir d'une bande métallique découpée et ils sont livrés fixés à une bordure de maintien et d'indexation. Usuellement, un module est inséré dans les contacts d'une portion de bande, puis il y est fixé par brasage, et ensuite les contacts sont séparés de la portion de bande par découpage. Enfin, l'ensemble du module et des contacts est placé sur le circuit rigide pour fixation par refusion de brasure.

Au moment où les contacts sont séparés de la portion de bande de maintien par une opération de découpage, ils peuvent, en raison notamment des contraintes mécaniques auxquelles ils ont été soumis, pivoter par rapport au module, autour d'une ligne qui est soit dans la direction d'insertion du module, soit dans le plan moyen du module et perpendiculaire à la direction d'insertion du module, soit perpendiculaire au plan moyen du module. Aussi, lors de la mise en place sur le circuit rigide de l'ensemble du module et des contacts, les pieds des contacts ne sont pas toujours dans la position correcte pour assurer une bonne fixation par refusion de brasure.

L'invention a pour but d'éviter les inconvénients des contacts existants en prévoyant des moyens simples de stabilisation des contacts sur le module et en supprimant, pour la qualité mécanique de la liaison entre contacts et module, l'influence de l'épaisseur de la brasure sur la pince.

L'invention a pour objet un contact électrique pour montage d'un module sur un circuit rigide, comportant une pince pour recevoir le module, constituée de deux bras recouverts d'une couche de brasure, caractérisé en ce que : chacun des bras de la pince présente au droit des zones de contact des bras avec le module, deux bossages écartés l'un de l'autre, dont la hauteur est sensiblement égale à l'épaisseur de la couche de brasure, de telle façon que le contact mécanique entre pince et module est pratiquement assuré directement par les bossages, et en ce que les deux bossages d'au moins un des deux bras de la pince sont disposés selon une ligne perpendiculaire à la direction d'insertion du module.

Selon d'autres caractéristiques :
- les bossages sont réalisés par poinçonnage,
- les bossages sont disposés selon des lignes perpendiculaires à la direction d'insertion du module,
- deux des bossages sont disposés selon une ligne parallèle à la direction d'insertion du module, et deux autres bossages sont disposés selon une ligne perpendiculaire à la direction d'insertion du module.

D'autres caractéristiques ressortent de la description qui suit, faite avec référence aux dessins annexés dans lesquels :
- la figure 1 est une vue en perspective d'un exemple de réalisation d'un contact à deux pieds selon l'invention,
- la figure 2 est une vue en coupe longitudinale selon la ligne II-II de la figure 3, du contact de la figure 1,
- la figure 3 est une vue en coupe selon la ligne III-III de la figure 2, du contact de la figure 1,
- la figure 4 est une vue en perspective d'un exemple de réalisation d'un contact à un seul pied selon l'invention,
- la figure 5 est une vue en coupe longitudinale selon la ligne V-V de la figure 6, du contact de la figure 4,
- la figure 6 est une vue en coupe selon la ligne VI-VI de la figure 5, du contact de la figure 4 ;
- la figure 7 est une vue en perspective d'un circuit rigide sur lequel sont fixés deux modules, au moyen de contacts de l'art antérieur.

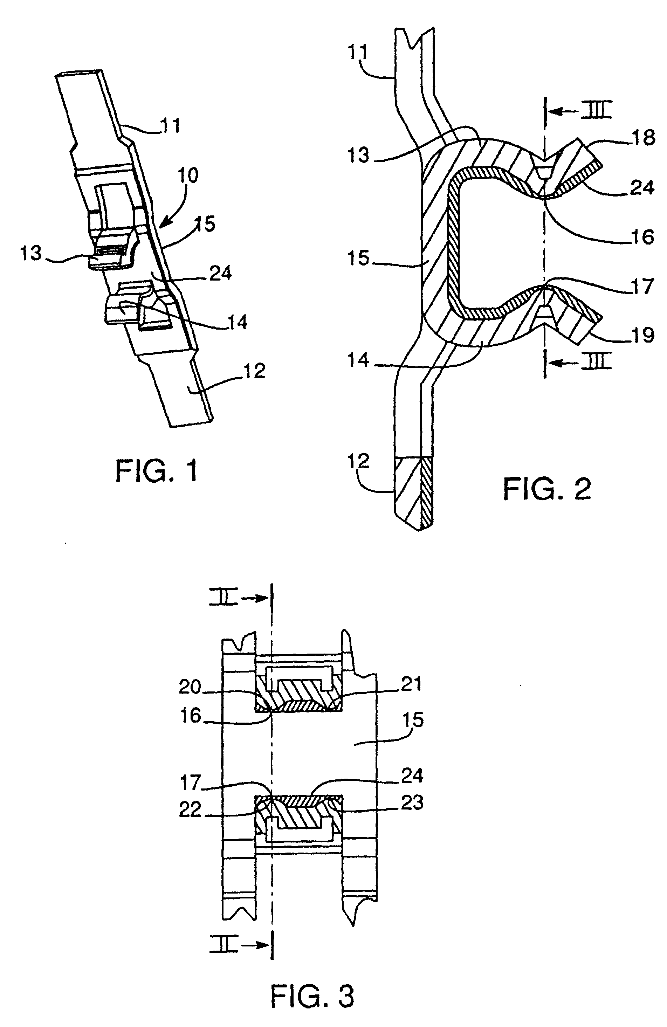

Sur la figure 1, le contact 10 est à deux pieds 11, 12. Il est destiné à être fixé sur un circuit rigide tel que celui de la figure 7, pour y supporter un module tel que 3, disposé perpendiculairement au circuit rigide. A cet effet, deux bras 13, 14 sont prélevés dans la matière du contact 10 et redressés et cintrés pour constituer une pince destinée à recevoir le module 3. Au-dessus de la partie centrale 15 du contact, le métal du contact est recouvert d'une couche de brasure 24, qui recouvre aussi les bras de la pince.

Sur la figure 2, les deux bras 13, 14 s'éloignent sensiblement perpendiculairement à la partie centrale 15 du contact, puis ils se rapprochent l'un de l'autre pour définir les zones de contact 16, 17 avec le module et ils s'éloignent l'un de l'autre jusqu'aux extrémités 18, 19. Au droit des zones de contact 16, 17, sont prévus des bossages 20,21 et 22, 23, respectivement, dans le métal des bras 13, 14, dont la hauteur est sensiblement égale à l'épaisseur de la couche de brasure 24. Ces bossages, visibles sur la figure 3, sont réalisés par poinçonnage par exemple, avant mise en forme du contact 10. Ils sont écartés deux à deux de façon à constituer ensemble quatre points de contact avec le module, répartis aux quatre sommets d'un rectangle par exemple.

Au droit des bossages 20-23, la couche de brasure 24 est très amincie, mais du fait que le poinçonnage est ponctuel, seule une petite quantité de matière est déplacée, ce qui n'affecte pas de manière sensible la stabilité de la brasure.

Ainsi, lors de l'insertion du module dans la pince constituée par les bras 13, 14, le contact mécanique entre pince et module est pratiquement assuré directement par les bossages 20-23. La disposition écartée des bossages deux à deux assure une stabilité de la position relative du contact et du module, et empêche la rotation du contact par rapport au module, au moins par rapport à une ligne située dans la direction d'insertion du module et par rapport à une ligne située perpendiculairement au plan moyen du module.

Sur la figure 4, le contact 30 est à un seul pied 31. Il est destiné à être fixé sur un circuit rigide tel que celui de la figure 7, pour y supporter un module tel que 5 disposé parallèlement au circuit rigide. A cet effet, la moitié supérieure du contact est repliée pour constituer une pince ayant un bras 32 sensiblement parallèle au plan du circuit rigide et un autre bras 33 cintré, entre lesquels est disposé un fond 34 sensiblement perpendiculaire au plan du circuit rigide et au premier bras 32 de la pince.

Sur les figures 5 et 6, le bras 32 présente, dans sa partie longitudinale centrale, deux bossages 35, 36 écartés l'un de l'autre et réalisés par poinçonnage par exemple. Le bras 33 présente, au droit de la zone de contact 37, la plus proche du bras 32, et correspondant à la région de cintrage du bras 33 vers l'extérieur, deux bossages 38 et 39. Les deux bossages 38 et 39 sont écartés l'un de l'autre et disposés sur une ligne dont la direction est perpendiculaire à celle de la ligne reliant les deux bossages 35, 36 du bras 32. Cette disposition des bossages, selon deux lignes écartées l'une de l'autre et de directions perpendiculaires entre elles, assure une stabilité de la position relative du contact par rapport au module, au moins par rapport à une ligne située dans la direction d'insertion du module, et par rapport à une ligne située dans le plan moyen du module et perpendiculaire à la direction d'insertion.

Pour une meilleure efficacité du contact mécanique entre la pince du contact et le module, il est souhaitable que les bossages soient aussi écartés que possible l'un de l'autre sur chaque bras de la pince. Il est cependant préférable que les bossages et la partie déformée de la brasure soient tout entiers compris dans la largeur du bras de la pince.

Dans l'exemple des figures 1 à 3, les bossages 20, 21, 22, 23 sont disposés sur des lignes perpendiculaires à la direction d'insertion du module. Dans l'exemple des figures 4 à 6, deux des bossages 35, 36 sont disposés sur une ligne parallèle à la direction d'insertion du module, et les deux autres bossages 38, 39, selon une ligne perpendiculaire à la direction d'insertion du module.

L'invention a été décrite dans deux modes de réalisation particuliers, mais n'est pas limitée à la forme particulière des contacts représentés pour autant qu'elle reste dans le cadre défini par les revendications suivantes.

## Revendications

1. Contact électrique pour montage d'un module sur un circuit rigide, comportant une pince pour recevoir le module, constituée de deux bras (13,14; 32,33) recouverts d'une couche de brasure (24), **caractérisé en ce que** chacun des bras (13,14 ; 32,33) de la pince présente au droit des zones de contact des bras (13,14 ; 32,33) avec le module, deux bossages (20, 21 ; 22, 23 ; 35, 36 ; 38,39) écartés l'un de l'autre, dont la hauteur est sensiblement égale à l'épaisseur de la couche de brasure (24), de telle façon que le contact mécanique entre pince et module est pratiquement assuré directement par les bossages (20-23, 35, 36, 38, 39), et **en ce que** les deux bossages (20-23, 38, 39) d'au moins un des deux bras (13, 14, 33) de la pince sont disposés selon une ligne perpendiculaire à la direction d'insertion du module.

2. Contact selon la revendication 1, **caractérisé en ce que** les bossages (20,21 ; 22,23 : 35,36 ; 38,39) sont réalisés par poinçonnage.

3. Contact selon la revendication 1, **caractérisé en ce que** les bossages (20,21 ; 22,23) dans les deux bras (13, 14) sont disposés selon des lignes perpendiculaires à la direction d'insertion du module.

4. Contact selon la revendication 1, **caractérisé en ce que** deux des bossages (35, 36) sont disposés selon une ligne parallèle à la direction d'insertion du module, et deux autres bossages (38, 39) sont disposés selon une ligne perpendiculaire à la direction d'insertion du module.

## Patentansprüche

1. Elektrischer Kontakt für die Montage eines Moduls auf einer Schaltungsplatte, mit einer Klemme zur Aufnahme des Moduls, bestehend aus zwei Armen (13, 14, 32, 33), die mit einer Lötschicht (24) bedeckt sind,
**dadurch gekennzeichnet, daß** jeder der Arme (13, 14, 32, 33) der Klemme an den Kontaktbereichen der Arme (13, 14, 32, 33) mit dem Modul zwei voneinander beabstandete Höcker (20, 21; 22, 23; 35, 36; 38, 39) aufweist, deren Höhe im wesentlichen gleich der Dicke der Lötschicht (24) ist, derart, daß der mechanische Kontakt zwischen der Klemme und dem Modul praktisch direkt durch die Höcker (20-23, 35, 36, 38, 39) bewirkt wird, und daß die beiden Höcker (20-23, 38, 39) mindestens eines der beiden Arme (13, 14, 33) der Klemme auf einer Linie angeordnet sind, die rechtwinklig zur Einschubrichtung des Moduls ist.

2. Kontakt nach Anspruch 1,
**dadurch gekennzeichnet, daß** die Höcker (20, 21; 22, 23; 35, 36; 38, 39) durch Prägen realisiert sind.

3. Kontakt nach Anspruch 1,
**dadurch gekennzeichnet, daß** die Höcker (20, 21; 22, 23) in den beiden Armen (13, 14) auf Linien angeordnet sind, die rechtwinkelig zur Einschubrichtung des Moduls sind.

4. Kontakt nach Anspruch 1,
**dadurch gekennzeichnet, daß** zwei Höcker (35, 36) auf einer Linie angeordnet sind, die parallel zur Einschubrichtung des Moduls ist, und daß zwei andere Höcker (38, 39) auf einer Linie angeordnet sind, die rechtwinklig zur Einschubrichtung des Moduls ist.

## Claims

1. Electrical contact for mounting a module on a rigid circuit board, comprising a set of jaws to receive the module, said jaws being made up of two arms (13, 14; 32, 33) covered with a layer of solder (24) **characterised in that** each of the arms (13, 14; 32, 33) of the set of jaws has, in line with the regions of the arms (13, 14; 32, 33) making contact with the module, two bosses (20, 21; 22, 23; 35, 36; 38, 39) which are spaced apart from one another and the height of which is substantially equal to the thickness of the solder layer (24), in such a way that mechanical contact between the jaws and the module is practically ensured directly by the bosses (20-23,35, 36, 38, 39) and **in that** the two bosses (20-23, 38, 39) of at least one of the two arms (13, 14, 33) of the jaws are disposed along a line perpendicular to the direction of insertion of the module.

2. Contact according to claim 1, **characterised in that** the bosses (20, 21; 22, 23; 35, 36; 38, 39) are realised by stamping.

3. Contact according to claim 1, **characterised in that** the bosses (20, 21; 22, 23) in the two arms (13, 14) are disposed along lines perpendicular to the direction of insertion of the module.

4. Contact according to claim 1, **characterised in that** two of the bosses (35, 36) are disposed along a line parallel to the direction of insertion of the module, and two other bosses (38, 39) are disposed along a line perpendicular to the direction of insertion of the module.
